# EUROPÄISCHE PATENTANMELDUNG

(11) **EP 2 088 132 A2**
(43) Veröffentlichungstag der Anmeldung: **12.08.2009**
(21) Anmeldenummer: 09000277.5
(22) Anmeldetag: 12.01.2009
(51) Int. Cl.: C03C 17/245, C23C 16/40, C23C 16/56

(54) **Verfahren zur Herstellung einer mit einem transparenten Metalloxid beschichteten Glasscheibe für ein photovoltaisches Modul**

(30) Priorität: 19.01.2008 DE 102008005283
(71) Anmelder: SCHOTT Solar GmbH, 63755 Alzenau (DE)
(72) Erfinder: Lechner, Peter, 85591 Vaterstetten (DE)
(74) Vertreter: Haft, von Puttkamer, Berngruber

(57) **Zusammenfassung**

Zur Herstellung einer mit einem transparenten, elektrisch leitfähigen Metalloxid (3) durch chemische Dampfabscheidung beschichteten Glasscheibe (1) als Ausgangsmaterial für ein photovoltaisches Modul wird eine chemische Dampfabscheidung des transparenten, elektrisch leitfähigen Metalloxid (3) auf der Glasscheibe (1) bei einer Beschichtungstemperatur durchgeführt, die höchstens 50 °C unterhalb der Transformationstemperatur des Glases liegt.

## Beschreibung

Die Erfindung bezieht sich auf ein Verfahren zur Herstellung einer durch chemische Dampfabscheidung mit einem transparenten, elektrisch leitfähigen Metalloxid beschichteten Glasscheibe als Ausgangsmaterial für ein photovoltaisches Modul. Sie hat auch eine solche mit einem transparenten, elektrisch leitfähigen Metalloxid beschichtete Glasscheibe zum Gegenstand, ferner eine Anlage zur Durchführung des Verfahrens.

Photovoltaische Module weisen auf einem transparenten Substrat, meist eine Glasscheibe, eine Frontelektrodenschicht auf, die aus einem transparenten, elektrisch leitfähigen Metalloxid (TCO) häufig Zinnoxid, besteht, und auf der Frontelektrodenschicht eine Halbleiterschicht, beispielsweise aus Silizium, sowie eine metallische Rückelektrodenschicht.

Das photovoltaische Modul besteht im Allgemeinen aus Zellen, die durch Kontakt der Rückelektrodenschicht einer Zelle mit der Frontelektrodenschicht der benachbarten Zelle serienverschaltet sind. Dazu werden z.B. mit einem Laserstrahl senkrecht zur Stromflussrichtung verlaufende Trennlinien gebildet. Das Modul wird zudem kontaktiert und häufig mit einem Rückenseitenschutz, der wiederum eine Glasscheibe oder auch eine Kunststofffolie sein kann, laminiert.

Aus Ausgangsmaterial zum Beschichten mit der Halbleiter- und der Rückelektrodenschicht wird eine Glasscheibe verwendet, die durch chemische Dampfabscheidung bei Atmosphärendruck (atmospheric pressure chemical vapor deposition oder APCVD) beschichtet worden ist.

Wenn das APCVD-Verfahren in den kontinuierlichen Prozess zur Herstellung von Floatglas integriert ist, spricht man auch vom "On-line"-APCVD-Verfahren. Die Beschichtungsquellen sind dabei in der Floatglasherstellungsanlage in einem Bereich positioniert, wo eine Glastemperatur von etwa 550 bis 700 °C herrscht. Danach wird das Glasband sehr langsam und definiert abgekühlt, sodass das Glas möglichst spannungsfrei wird.

Demgegenüber werden nach dem "Off-line"-APCVD-Verfahxen auf Endmaß zugeschnittene Glasscheiben in einer eigenen Beschichtungsanlage mit dem transparenten, elektrisch leitfähigen Metalloxid beschichtet. Dazu werden die Glasscheiben vor dem Beschichten in einer Aufheizzone auf etwa 450 bis 550 °C aufgeheizt. Danach werden die mit dem transparenten, elektrisch leitfähigen Metalloxid beschichteten Glasscheiben langsam und definiert abgekühlt, sodass sie möglichst spannungsfrei werden.

Bei vielen Anwendungen eines photovoltaischen Moduls sind die Anforderungen an die mechanische Festigkeit (z.B. durch Schneelast) oder die thermische Belastbarkeit (z.B. durch partielle Abschattung oder abrutschenden Schnee) im Betrieb sehr hoch. Dem werden die nach dem "On-line"- oder "Off-line"-APCVD-Verfahren beschichteten Glasscheiben jedoch nicht gerecht, da sie eine Biegefestigkeit von lediglich 45 N/mm² und eine Temperaturwechselfestigkeit von lediglich 40 K besitzen (gemäß EN 572-1). Es besteht daher ein erhebliches Bruchrisiko für das photovoltaische Modul beim Betrieb des Moduls, z.B. auf einem Dach oder im Feld, aber auch bei der Herstellung, beim Transport und der Montage. Gewährleistungsansprüche in derartigen Schadensfällen können dramatische Auswirkungen auf den Hersteller der photovoltaischen Module haben.

Um derartige Risiken zu minimieren, kann die nach dem "On-line"- oder dem "Off-line"-APCVD-Verfahren mit dem transparenten, elektrisch leitfähigen Metalloxid beschichtete Glasscheibe vor der Weiterverarbeitung zu einem photovoltaischen Modul in einem weiteren, separaten Prozessschritt thermisch oder chemisch vorgespannt oder gehärtet werden. Damit erhält es die gewünschte mechanisch Festigkeit uhd thermische Belastbarkeit.

Bei der üblichen thermischen Vorspannung wird dadurch die nach dem "On-line"- oder "Off-linell-APCVD-Verfahren beschichtete Glasscheibe zu Einscheiben-Sicherheitsglas mit einer Biegefestigkeit von mehr als 120 N/mm² (gemäß EN 12150-1) oder zu einem teilvorgespannten Glas mit einer Biegefestigkeit mehr als 70 N/mm² (gemäß EN 1863-1)verarbeitet. Diese Festigkeitswerte sind durch die Prüfnorm EN 1288-3 festgelegt.

Die thermische Vorspannung ist jedoch mit einem zusätzlichen Aufwand und damit zusätzlichen Kosten verbunden. Als weiteren Nachteil hat das thermische Vorspannen eine mehr oder weniger starke Welligkeit bzw. Verwerfung der Glasscheibe von bis zu 3 mm pro 1000 mm ("generelle Verwerfung") bzw. 0,3 mm pro 300 mm (lokale Verwerfung") zur Folge. Diese Welligkeit ist zwar normgerecht, kann jedoch die Prozessierung eines photovoltaischen Dünnschichtmoduls unmöglich machen, beispielsweise bei der Abscheidung der Halbleiterschicht durch Plasma unterstützte chemische Dampfabscheidung (plasma enhanced chemical vapor deposition oder PECVD), insbesondere bei einem kleinen Elektroden-Substrat-Abstand der PECVD-Anlage, und vor allem bei der Laserstrukturierung, da ein Laserstrahl bei einer derartigen Welligkeit nicht mehr hinreichend fokussiert werden kann.

Aufgabe der Erfindung ist es daher, eine mit einem transparenten, elektrisch leitfähigen Metalloxid beschichtete Glasscheibe als Ausgangsmaterial für die Herstellung eines photovoltaischen Moduls zur Verfügung zu stellen, die eine hohe Biegefestigkeit und Temperaturwechselfestigkeit sowie eine geringe Welligkeit aufweist und zudem kostengünstig herstellbar ist.

Dies wird erfindungsgemäß mit dem im Anspruch 1 gekennzeichneten Verfahren erreicht. In den Ansprüchen 2 bis 9 sind vorteilhafte Ausgestaltungen des erfindungsgemäßen Verfahrens wiedergegeben. Die Ansprüche 10 bis 12 betreffen eine nach dem erfindungsgemäßen Verfahren hergestellte mit einem transparenten, elektrisch leitfähigen Metalloxid beschichtete Glasscheibe. Der Anspruch 13 hat eine chemische Dampfabscheidungsanlage zur Durchführung des erfindungsgemäßen Verfahrens zum Gegenstand.

Nach dem erfindungsgemäßen Verfahren wird eine auf das Endmaß des herzustellenden photovoltaischen Moduls zugeschnittene Glasscheibe der Anlage zur Beschichtung mit dem transparenten, elektrisch leitfähigen Metalloxid durch chemische Dampfabscheidung zugeführt.

Dabei weist die Glasscheibe in der Anlage bei der Beschichtung eine Beschichtungstemperatur auf, die der Transformationstemperatur Tg des Glases zumindest annähernd entspricht.

Die Glasscheibe kann dabei aus Kalk-Natron-Glas, Borosilikat-Glas oder einem anderen Glas bestehen. Als transparentes, elektrisch leitfähiges Metalloxid kann auf die Glasscheibe beispielsweise Zinnoxid (SnO₂), insbesondere mit Fluor dotiertes Zinnoxid (SnO₂:F) abgeschieden werden oder z.B. Zinkoxid (ZnO).

Die Beschichtung der Glasscheibe mit dem transparenten, elektrisch leitfähigen Metalloxid bei einer der Transformationstemperatur Tg entsprechenden Beschichtungstemperatur wird vorzugsweise durch chemische Dampfabscheidung bei Atmosphärendruck durchgeführt (APCVD-Verfahren). D.h. es wird eine APCVD-Anlage verwendet, die so ausgebildet ist, dass die Glasscheibe eine Beschichtungstemperatur nahe der Transformationstemperatur Tg des Glases besitzt.

Die Beschichtungstemperatur sollte nicht mehr als 50 °C, vorzugsweise nicht mehr als 30 °C, insbesondere nicht mehr als 20 °C unterhalb der Transformationstemperatur Tg des Glases liegen.

Die für photovoltaische Module üblicherweise verwendeten Glasscheiben aus Kalk-Natron-Glas oder dergleichen werden daher auf eine Beschichtungstemperatur von mehr als 540 °C, insbesondere mehr als 570 °C aufgeheizt, worauf die Beschichtung mit dem transparenten, elektrisch leitfähigen Metalloxid durch chemische Dampfabscheidung erfolgt.

Überraschenderweise führt die hohe Beschichtungstemperatur zu einer verbesserten Leitfähigkeit der transparenten, elektrisch leitfähigen Metalloxidschicht, ohne dass die optische Absorption im IR-Bereich erhöht wird.

Unmittelbar nach dem Beschichten mit dem transparenten, elektrisch leitfähigen Metalloxid wird die Glasscheibe von der Beschichtungstemperatur nahe der Transformationstemperatur Tg rasch abgekühlt. Dadurch wird das Glas vorgespannt und damit eine hohe Biegefestigkeit und Temperaturwechselfestigkeit erzielt. Um die gewünschte Vorspannung auszubilden, sollte die Abkühlgeschwindigkeit beim Abkühlen der beschichteten Glasscheibe von der Beschichtungstemperatur mindestens 20 K/min betragen. Vorzugsweise liegt die Abkühlgeschwindigkeit bei 20 bis 300 K/min, insbesondere 50 bis 200 K/min. Diese Abkühlgeschwindigkeit wird aufrecht erhalten, bis die mit dem transparenten, elektrisch leitfähigen Metalloxid beschichtete Glasscheibe auf mindestens 450 °C abgekühlt worden ist.

Dabei wird das Abkühlen vorzugsweise durch beidseitiges Anblasen der mit dem transparenten, elektrisch leitfähigen Metalloxid beschichteten Glasscheibe durchgeführt. Zum Anblasen kann Luft oder ein anderes Gas verwendet werden.

Bevorzugt werden erfindungsgemäß Glasscheiben mit einer Dicke von 3 bis 6 mm beschichtet. Bei den größeren Dicken sind tendenziell langsamere Abkühlgeschwindigkeiten als bei den kleineren Dicken einzustellen.

Die Beschichtungstemperatur und die Abkühlgeschwindigkeit können je nach Glasart (Kalk-Natron-Glas, Borosilikat-Glas oder dergleichen) und Dicke der Glasscheibe so eingestellt werden, dass die beschichtete Glasscheibe eine Biegefestigkeit von mehr als 120 N/mm² aufweist, also eine Biegefestigkeit, die der von Einscheiben-Sicherheitsglas entspricht.

Vorzugsweise wird die Abkühlgeschwindigkeit jedoch in Abhängigkeit von Beschichtungstemperatur, Glasart und Dicke der Glasscheibe so eingestellt, dass eine Biegefestigkeit von 50 bis 120 N/mm², insbesondere 60 bis 100 N/mm² erhalten wird. Die Biegefestigkeit wird dabei nach der Prüfnorm EN 1288-3 bestimmt.

Wenn die Abkühlgeschwindigkeit so eingestellt wird, dass die Biegefestigkeit unter 120 N/mm² liegt, kann nämlich die Welligkeit der Glasscheibe auf Werte unter 1 mm pro Meter, insbesondere 0,8 mm pro Meter und sogar auf weniger als 0,5 mm pro Meter herabgesetzt werden.

Damit kann erfindungsgemäß ein photovoltaisches Dünnschichtmodul z.B. mit einem Laser äußerst genau strukturiert werden, wobei die Halbleiterschicht z.B. auch mit einer PECVD-Anlage aufgebracht werden kann, die einen sehr kleinen Elektroden-Substrat-Abstand aufweist.

Gleichzeitig wird durch die erfindungsgemäße hohe Beschichtungstemperatur nahe der Transformationstemperatur Tg des Glases und die rasche Abkühlung der beschichteten Glasplatte eine hohe Temperaturwechselfestigkeit von mehr als 50 K, insbesondere mehr als 70 K erreicht. Zur Biegefestigkeit und Temperaturwechselfestigkeit des erfindungsgemäßen vorzugsweise erhaltenen, teilvorgespannten Glases ist auf die Norm EN 1863 hinzuweisen.

Aufgrund der hohen Beschichtungstemperatur nahe der Transformationstemperatur Tg des Glases wird erfindungsgemäß vorzugsweise eine teilvorgespannte Glasscheibe erzeugt, die mit einer hervorragenden transparenten, elektrisch leitfähigen Metalloxidschicht beschichtet ist. Durch die rasche Abkühlung nach der Beschichtung weist die beschichtete Glasscheibe eine hohe Biegefestigkeit und eine hohe Temperaturwechselfestigkeit und zugleich eine wesentlich geringere Welligkeit als normgerechtes, thermisch vorgespanntes Glas auf.

Die erfindungsgemäße hergestellte, mit dem transparenten, elektrisch leitfähigen Metalloxid beschichtete Glasscheibe stellt das Ausgangsmaterial zur Herstellung eines photovoltaischen Moduls dar. Dazu wird die erfindungsgemäß hergestellte, mit dem transparenten, elektrisch leitfähigen Metalloxid beschichtete Glasscheibe mit einer Halbleiter- und Rückelektrodenschicht beschichtet, dazwischen mit einem Laser so bearbeitet, dass sich eine integrierte Serienverschaltung der einzelnen Solarzellen ausbildet, dann kontaktiert und schließlich mit einem Rückseitenschutz, der wiederum eine Glasscheibe oder auch eine Kunststofffolie sein kann, laminiert. Die Halbleiterschicht kann aus Silizium (amorphes, nanokristallines und polykristallines Silizium) oder einem anderen Halbleiter wie z.B. Cadmium/Tellur bestehen.

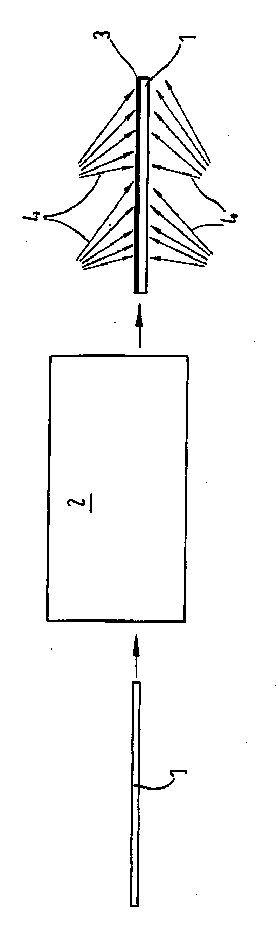

Nachstehend ist die Erfindung anhand der beigefügten Zeichnung beispielhaft näher erläutert, deren einzige Figur schematisch die Herstellung einer mit einem transparenten, elektrisch leitfähigen Metalloxid beschichteten Glasscheibe zur Herstellung eines photovoltaischen Moduls zeigt.

Danach wird eine auf das Endmaß der herzustellenden photovoltaischen Moduls zugeschnittene Glasplatte 1 einer Anlage 2 zur chemischen Dampfabscheidung des transparenten, elektrisch leitfähigen Metalloxids 3 bei einer Beschichtungstemperatur, die der Transformationstemperatur Tg des Glases entspricht, zugeführt. Die aus der Anlage 2 austretende, mit der transparenten, elektrisch leitfähigen Metalloxid-Schicht 3 versehene Glasscheibe 1 wird mit einem Gas 4 beidseitig angeblasen und dadurch abgeschreckt.

## Patentansprüche

1. Verfahren zur Herstellung einer mit einem transparenten, elektrisch leitfähigen Metalloxid (3) durch chemische Dampfabscheidung beschichteten Glasscheibe (1) als Ausgangsmaterial für ein photovoltaisches Modul, **dadurch gekennzeichnet, dass** die chemische Dampfabscheidung des transparenten, elektrisch leitfähigen Metalloxid (3) auf der Glasscheibe (1) bei einer Beschichtungstemperatur durchgeführt wird, die höchstens 50 °C unterhalb der Transformationstemperatur des Glases liegt.

2. Verfahren nach Anspruch 1, **dadurch gekennzeichnet, dass** die Beschichtungstemperatur, bei der die chemische Dampfabscheidung auf der Glasscheibe (1) durchgeführt wird, höchstens 20 °C unterhalb der Transformationstemperatur des Glases liegt.

3. Verfahren nach Anspruch 1 oder 2, **dadurch gekennzeichnet, dass** die mit dem transparenten, elektrisch leitfähigen Metalloxid (3) beschichtete Glasscheibe (1) von der Beschichtungstemperatur mit einer Abkühlgeschwindigkeit von mindestens 20 K/min abgekühlt wird.

4. Verfahren nach Anspruch 3, **dadurch gekennzeichnet, dass** die Abkühlgeschwindigkeit 50 bis 200 K/min beträgt.

5. Verfahren nach Anspruch 1, **dadurch gekennzeichnet, dass** die Abkühlung mit der Abkühlgeschwindigkeit nach dem Anspruch 3 oder 4 durchgeführt wird, bis die mit dem transparenten, elektrisch leitfähigen Metalloxid (3) beschichtete Glasscheibe (1) auf mindestens 450 °C abgekühlt worden ist.

6. Verfahren nach einem der Ansprüche 3 bis 5, **dadurch gekennzeichnet, dass** das Abkühlen durch beidseitiges Anblasen (4) der mit dem transparenten, elektrisch leitfähigen Metalloxid (3) beschichteten Glasscheibe (1) erfolgt.

7. Verfahren nach Anspruch 1, **dadurch gekennzeichnet, dass** die chemische Dampfabscheidung bei Atmosphärendruck durchgeführt wird.

8. Verfahren nach Anspruch 1, **dadurch gekennzeichnet, dass** eine Glasscheibe (1) mit einer Dicke von 3 bis 6 mm verwendet wird.

9. Verfahren nach Anspruch 1, **dadurch gekennzeichnet, dass** die Glasscheibe (1) mit Zinnoxid als transparentem, elektrisch leitfähigem Metalloxid (3) beschichtet wird.

10. Glasscheibe, die nach einem der vorstehenden Ansprüche hergestellt worden ist, **dadurch gekennzeichnet, dass** sie eine Biegefestigkeit von 50 bis 120 N/mm² aufweist.

11. Glasscheibe, die nach einem der Ansprüche 1 bis 9 hergestellt worden ist, **dadurch gekennzeichnet, dass** sie eine Welligkeit von weniger als 1 mm, insbesondere weniger als 0,5 mm pro Meter aufweist.

12. Glasscheibe, die nach einem der Ansprüche 1 bis 9 hergestellt worden ist, **dadurch gekennzeichnet, dass** sie eine Temperaturwechselfestigkeit von mehr als 50 K, insbesondere mehr als 70 K aufweist.

13. Chemische Dampfabscheidungsanlage zur Durchführung des Verfahrens nach Anspruch 1, **dadurch gekennzeichnet, dass** sie so ausgebildet ist, dass die Glasscheibe (1) beim Beschichten mit dem transparenten, elektrisch leitfähigen Metalloxid (3) eine Beschichtungstemperatur aufweist, die höchstens 50 °C unterhalb der Transformationstemperatur des Glases liegt.
